# EUROPEAN PATENT APPLICATION

(11) **EP 2 453 725 A1**
(43) Date of publication of application: **16.05.2012**
(21) Application number: 10796873.7
(22) Date of filing: 24.06.2010
(51) Int. Cl.: H05K 1/11, H01L 23/36, H05K 1/02, H05K 3/00, H05K 3/40

(54) **THROUGH-WIRING BOARD AND METHOD OF MANUFACTURING SAME**

(30) Priority: 10.07.2009 JP 2009164001
(71) Applicant: Fujikura, Ltd., Tokyo 135-8512 (JP)
(72) Inventor: YAMAMOTO, Satoshi, Sakura-shi Chiba 285-8550 (JP); HASHIMOTO, Hirokazu, Sakura-shi Chiba 285-8550 (JP)
(74) Representative: Cabinet Plasseraud
(86) International application number: PCT/JP2010/004192
(87) International publication number: WO 2011/004559

(57) **Abstract**

A through wiring substrate includes a substrate including a first face and a second face, and a plurality of through-wires formed by filling, or forming a film of, an electrically-conductive substance in through-holes that penetrate between the first face and the second face. The through-wires are separated from each other, and, include at least one overlap section in a plan view of the substrate.

## Description

### TECHNICAL FIELD

The present invention relates to a through wiring substrate including a through-wire that penetrates the interior of the substrate (interposer substrate with through-hole interconnection), and a manufacturing method thereof.
Priority is claimed on Japanese Patent Application No. 2009-164001, filed July 10, 2009, the content of which is incorporated herein by reference.

### BACKGROUND ART

Conventionally, a method of providing a through-wire that penetrates the interior of a substrate (through-hole interconnection) is used as a method of electrically connecting a first device, mounted on a first face which is one face of the substrate, to a second device, mounted on a second face which is another face. The substrate with the through-wire is often called interposer.
As an example of a through wiring substrate (interposer), Patent Document 1 describes a through wiring substrate including a through-wire made by filling an electrically-conductive substance into a microscopic hole having a section that extends in a direction different from the thick direction of the base material.

Patent Document 2 describes a semiconductor chip stacked module. In a semiconductor chip stacked package wherein a plurality of through-wires penetrating from a first face, which is one face of a chip body, to a second face, which is another face, are embedded, in order to prevent an electrically-conductive substance filled into the through-wires from falling out from the base material forming the through-hole, a through-hole of the semiconductor laminated module according to the Patent Document 2 is formed inclined towards a direction perpendicular to a main plane of the chip body. An opening in the first face side and an opening in the second face side of the through-hole are formed with a deviation of an integral multiple (N□1) of the pitch α of the through-hole, with respect to a projection of the thick direction of the substrate of the chip body, and electrodes of adjacent semiconductor chips are electrically connected with deviation of N portions in the direction of deviation X.

### PRIOR ART DOCUMENT

### PATENT DOCUMENT

[Patent Document 1]: Japanese Unexamined Patent Application, First Publication No. 2006-303360
[Patent Document 2]: Japanese Patent No. 3896038

### DISCLOSURE OF THE INVENTION

### PROBLEMS TO BE SOLVED BY THE INVENTION

When different devices are mounted on a first face, which is one face of a substrate, and a second face, which is another face, the electrode arrangements of the devices are different. Therefore, there is a demand for a high degree of freedom in designing the wiring of through-wires in the substrate. When each device has a great number of electrodes on a face opposite the substrate, miniaturizing the devices will make the intervals between the electrodes narrower. In a through wiring substrate with a plurality of through-wires provided thereon, there must be spatial distance between the through-wires in order to avoid shorting between the through-wire and interference between their electrical signals. Today, in addition to increasingly diversified electrode arrangements, electrode densities are becoming higher, and hence there is a desire to develop through-wiring technology that will achieve a higher degree of design freedom in wiring for through wiring substrates than has hitherto been possible.

The present invention has been realized in view of these issues, and aims to provide a through wiring substrate and a manufacturing method thereof that, even in miniature devices with diverse electrode arrangements are mounted at high density on both faces of the through wiring substrate, can enable the electrodes of the mounted devices to be electrically connected with a high degree of freedom.

### MEANS FOR SOLVING THE PROBLEMS

To solve the problems described above, the invention employs the followings.
A through wiring substrate according to an aspect of the invention includes a substrate including a first face and a second face; and a plurality of through-wires formed by filling, or forming a film of, an electrically-conductive substance in through-holes that penetrate between the first face and the second face; wherein the through-wires are separated from each other, and include at least one overlap section in a plan view of the substrate.
A flow path can be formed in the interior of the substrate.
The plurality of through-wires can include a plurality of first through-wires, formed along a first direction parallel with the first face of the substrate, and a plurality of second through-wires, formed along a second direction that intersects the first direction.
The plurality of through-wires can include a first conductive part, formed on the first face of the substrate, and a second conductive part, formed on the second face of the substrate; the first and second conductive parts are formed at mutually different positions when viewed from a thick direction of the substrate.
A method of manufacturing a through wiring substrate according to the other aspect of the invention is a method of manufacturing a through wiring substrate which comprises a substrate including a first face and a second face, and a plurality of through-wires formed by filling, or forming a film of, an electrically-conductive substance in through-holes that penetrate between the first face and the second face, in which the through-wires are separated from each other, and include at least one overlap section in a plan view of the substrate; the method includes a process (A) of laser-irradiating a plurality of through-hole formation regions which are separated from each other and include an overlap section in a plan view of the substrate, from the first face or the second face of the substrate, and thereby modifying the through-hole formation regions, and a process (B) of removing the modified through-hole formation regions to form through-holes. In process (A), of the plurality of through-hole formation regions, after laser-irradiating the overlap section which is far from the laser incident face, the overlap section which is near to the laser incident face is laser-irradiated.
In process (A), after laser-irradiating the entirety of the through-hole formation region having the overlap section far from the laser incident face, the entirety of the through-hole formation region having the overlap section near to the laser incident face can be laser-irradiated.
A method of manufacturing a through wiring substrate according to the other aspect of the invention is a method of manufacturing a through wiring substrate which comprises a substrate including a first face and a second face, and a plurality of through-wires formed by filling, or forming a film of, an electrically-conductive substance in through-holes that penetrate between the first face and the second face, in which the through-wires are separated from each other, and include at least one overlap section in a plan view of the substrate, the method includes a process (A) of laser-irradiating a plurality of through-hole formation regions which are separated from each other and include an overlap section in a plan view of the substrate, from the first face and the second face of the substrate, and thereby modifying the through-hole formation regions, and a process (B) of removing the modified through-hole formation regions to form through-holes. In process (A), the through-hole formation regions including the overlap section near to the first face are laser-irradiated from the first face side of the substrate, and the through-hole formation regions including the overlap section which is near to the second face are laser-irradiated from the second face side of the substrate.
The method can also include a process (C) of filling, or forming a film of, the electrically-conductive substance in the through-holes.

### EFFECTS OF THE INVENTION

According to the invention, it is possible to provide a through wiring substrate including a plurality of through-wires which are separated from each other and, have an overlap section in a plan view of the substrate, and a manufacturing method thereof.
Since the through-wires provided in the through wiring substrate of the invention can be freely arranged in the substrate in accordance with the positions of the electrodes on each of the devices mounted on each of the faces of the substrate, the devices can be freely connected even if the devices are miniaturized devices with electrodes arranged at high density.

### BRIEF DESCRIPTION OF THE DRAWINGS

FIG 1A is a plan view showing a through wiring substrate according to a first embodiment of the invention.
FIG 1B is a cross-sectional view of a through wiring substrate along the line a-a of FIG 1A.
FIG 1C is a cross-sectional view of a through wiring substrate along the line b-b of FIG 1A.
FIG 2A is a plan view showing a through wiring substrate according to a second embodiment of the invention.
FIG 2B is a cross-sectional view of a through wiring substrate along the line a-a of FIG 2A.
FIG 2C is a cross-sectional view of a through wiring substrate along the line b-b of FIG 2A.
FIG 3A is a plan view showing a through wiring substrate according to a third embodiment of the invention.
FIG 3B is a cross-sectional view of a through wiring substrate along the line a-a of FIG 3A.
FIG 3C is a cross-sectional view of a through wiring substrate along the line b-b of FIG 3A.
FIG 4A is a plan view showing a through wiring substrate according to a fourth embodiment of the invention.
FIG 4B is a cross-sectional view of a through wiring substrate along the line a-a of FIG 4A.
FIG 4C is a cross-sectional view of a through wiring substrate along the line b-b of FIG 4A.
FIG 5A is a plan view showing a through wiring substrate according to a fifth embodiment of the invention.
FIG 5B is a cross-sectional view of a through wiring substrate along the line a-a of FIG 5A.
FIG 5C is a cross-sectional view of a through wiring substrate along the line b-b of FIG 5A.
FIG 6A is a plan view showing a through wiring substrate according to a sixth embodiment of the invention.
FIG 6B is a cross-sectional view of a through wiring substrate along the line a-a of FIG 6A.
FIG 6C is a cross-sectional view of a through wiring substrate along the line b-b of FIG 6A.
FIG 7A is a plan view showing a method of manufacturing a through wiring substrate according to the invention.
FIG 7B is a cross-sectional view along the line a-a of FIG 7A.
FIG 7C is a cross-sectional view along the line b-b of FIG 7A.
FIG 8A is a plan view showing a method of manufacturing a through wiring substrate according to the invention.
FIG 8B is a cross-sectional view along the line a-a of FIG 8A.
FIG 8C is a cross-sectional view along the line b-b of FIG 8A.
FIG 9A is a plan view showing a method of manufacturing a through wiring substrate according to the invention.
FIG 9B is a cross-sectional view along the line a-a of FIG 9A.
FIG 9C is a cross-sectional view along the line b-b of FIG 9A.
FIG 10A is a plan view showing a method of manufacturing a through wiring substrate according to the invention.
FIG 10B is a cross-sectional view along the line a-a of FIG 10A.
FIG 10C is a cross-sectional view along the line b-b of FIG 10A.
FIG 11A is a plan view showing a method of manufacturing a through wiring substrate according to the invention.
FIG 11B is a cross-sectional view along the line a-a of FIG 11A.
FIG 11C is a cross-sectional view along the line b-b of FIG 11A.
FIG 12A is a plan view showing a method of manufacturing a through wiring substrate according to the invention.
FIG 12B is a cross-sectional view along the line a-a of FIG 12A.
FIG 12C is a cross-sectional view along the line b-b of FIG 12A.
FIG 13A is a plan view showing a method of manufacturing a through wiring substrate according to the invention.
FIG 13B is a cross-sectional view along the line a-a of FIG 13A.
FIG 13C is a cross-sectional view along the line b-b of FIG 13A.

### DETAILED DESCRIPTION OF THE PREFERRED EMBODIMENTS

Embodiments of the invention will be explained with reference to the drawings.

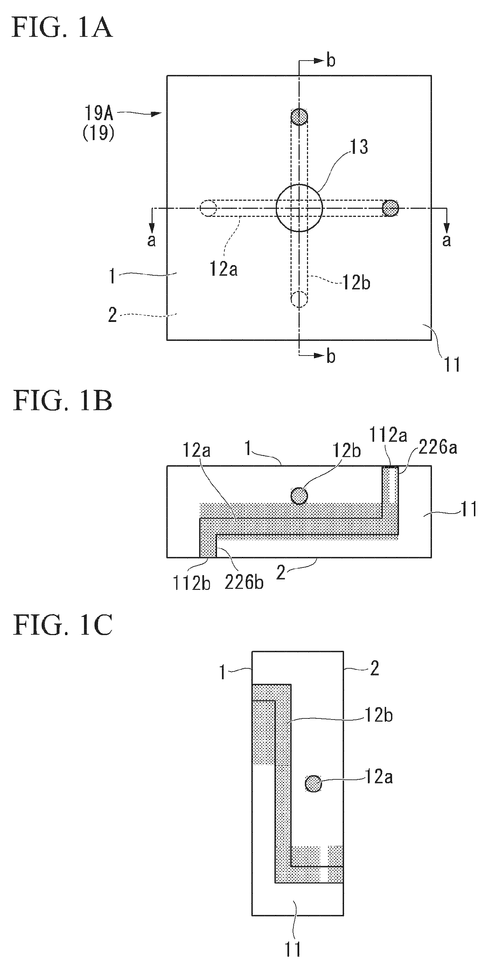

FIGS. 1A to 6C are plan views and cross-sectional views of through wiring substrates 19 according to embodiments of the invention. As shown in FIGS. 1A to 6C, each through wiring substrate 19 according to the embodiments of this invention includes a plurality of through-wires that penetrate two or more faces constituting a single substrate 11. Moreover, each through wiring substrate 19 includes at least one overlap section 13 (intersecting part) where, as viewed from the overlap direction of two faces (first face and second face) forming the top and bottom of the substrate 11, the through-wires are separated from each other while overlapping. That is, the through-wires of the through wiring substrate 19 are separated from each other, and, in a plan view of the substrate, include at least one overlap section 13.
That is, each through wiring substrate 19 according to the embodiments of the invention includes a plurality of through-wires which three-dimensionally intersect or three-dimensionally overlap when viewed from the overlap direction of the two faces forming the top and bottom of the substrate 11. Here, 'three-dimensionally overlap' is a concept that includes 'three-dimensionally intersect'. An example of a case where the through-wires 'three-dimensionally overlap but do not three-dimensionally intersect' is one where the plurality of through-wires are disposed three-dimensionally in parallel. Furthermore, 'two faces forming the top and bottom' denotes a first face and a second which have the largest areas of the plurality of faces constituting the substrate 11.
By disposing the plurality of through-wires in the substrate 11, the wiring can be designed with great freedom so as to match the positions of electrodes of devices mounted on the faces of the through wiring substrate 19. Therefore, devices with mutually different electrode arrangements with electrodes arranged at high density can be electrically connected via the through wiring substrate 19 according to the invention.

The through wiring substrate 19 according to the invention preferably has flow paths in it. These flow paths are used for flowing, for example, cooling fluid. Thus, even if the mounted devices generate a large amount of heat, they can be cooled effectively. The flow paths can be provided along the entirety of the substrate 11, or the flow paths can be provided in concentration at positions that overlap with the heat-generating parts of the mounted devices.

There are no particular restrictions on the shapes of the through-wires and the flow paths disposed in the through wiring substrate 19 according to the embodiments of the invention; acceptable shapes include, for example, linear parts, curved parts, bend parts, and folded parts. These shapes of the through-wires and the flow paths can be combined as appropriate.

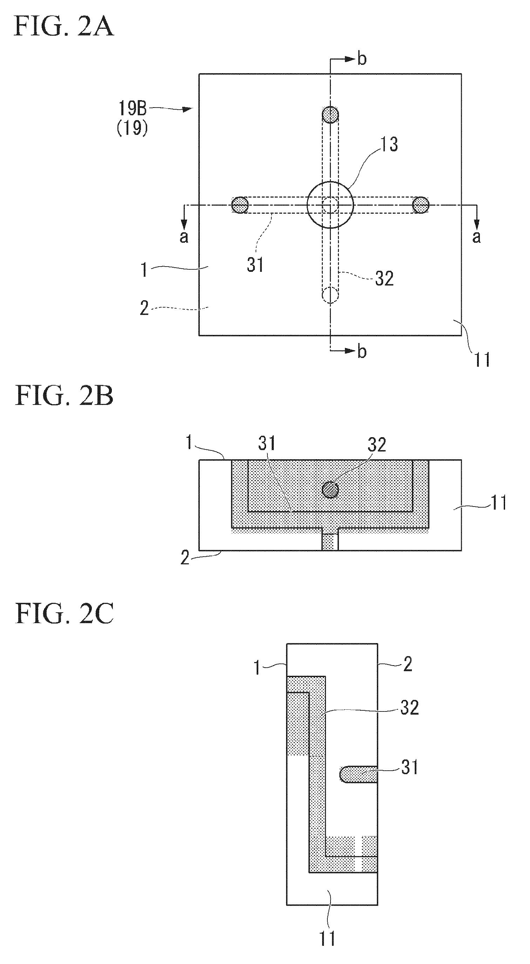

FIGS. 1A to 1C are views of a through wiring substrate 19A (19) according to a first embodiment of the invention. FIG 1A is a plan view of the through wiring substrate 19A. FIG 1B is a cross-sectional view of the through wiring substrate 19A along the line a-a in the plan view of FIG 1A. FIG 1C is a cross-sectional view of the through wiring substrate 19A along the line b-b in the plan view of FIG 1A.
The through wiring substrate 19A includes through-wires 12a and 12b disposed in the substrate 11. When viewed from the overlap direction of a first face and a second face, the through-wires 12a and 12b include an overlap section 13 where the through-wires are separated from each other while overlapping. Here, a first face indicates a face on the front side of the paper face of FIG 1A (top face), and a second face represents a face on the rear side of the paper face (bottom face). In other words, when viewed in the thick direction of the substrate 11, the through-wires 12a and 12b include an overlap section 13 where they are separated from each other while overlapping. The thick direction of the substrate 11 indicates a direction from a first face to a second face forming the top and bottom of the substrate 11 (or the reverse direction). For sake of convenience in FIG 1A, the overlap section 13 is represented by a circle. Strictly speaking, however, the overlap section 13 represents only an intersection of the through-wire 12a and the through-wire 12b viewed in the thickness direction of the substrate 11. The same goes for FIGS. 2A to 13C described later.

As shown in FIGS. 1A to 1C, the through-wires 12a and 12b are both crank-shaped.
As shown in FIGS. 1A and 1B, one end of the through-wire 12a is a first conductive part 112a exposed at the first face 1. Another end of the through-wire 12a is a second conductive part 112b exposed at the second face 2. Among it, a linear part constituting the through-wire 12a extends from the one end (first conductive part 112a) of the through-wire 12a in the thick direction of the substrate 11, and reaches a substantially right-angled first bend part. From the substantially right-angled first bend part, the linear part continues extending in parallel with both faces (the first face and the second face) of the substrate 11, and reaches a substantially right-angled second bend part. From the substantially right-angled second bend part, the linear part continues extending in the thick direction of the substrate 11, and reaches the second conductive part exposed at the second face 2.
As shown in FIGS. 1A and 1C, the through-wire 12b is crank-shaped similar to the through-wire 12a. A first conductive part of the through-wire 12b is provided on the first face 1 at a position different from the first conductive part of the through-wire 12a. A substantially right-angled first bend part of the through-wire 12b is provided at a position nearer the first face 1 (nearer the top-face side) than the substantially right-angled first bend part of the through-wire 12a. Moreover, the extension direction of the linear part, which extends from the substantially right-angled first bend part to the substantially right-angled second bend part of the through-wire 12b, is 90 degrees different from the extension direction from the substantially right-angled first bend part to the substantially right-angled second bend part of the through-wire 12a. Therefore, the through-wire 12a and the through-wire 12b do not interfere with each other by making contact with each, and, when viewed from the overlap direction of the two faces of the substrate 11 (in plan view), they are separated from each other and overlapping at an overlap section 13, where they three-dimensionally intersect and overlap.

FIGS. 2A to 2C are views of a through wiring substrate 19B (19) according to a second embodiment of the invention. FIG 2A is a plan view of the through wiring substrate 19B. FIG 2B is a cross-sectional view of the through wiring substrate 19B along the line a-a in the plan view of FIG 2A. FIG 2C is a cross-sectional view of the through wiring substrate 19B along the line b-b in the plan view of FIG 2A.
The through wiring substrate 19B includes through-wires 31 and 32 disposed in the substrate 11. As shown in FIG 2A, viewed from the overlap direction of a first face and a second face forming the top and bottom of the substrate 11 (the thick direction of the substrate 11), the through-wires 31 and 32 include an overlap section 13 where they are separated from each other while overlapping.

As shown in FIGS. 2B and 2C, the through-wire 31 is substantially Y-shaped, and the through-wire 32 is crank-shaped.
The through-wire 31 includes a first conductive part exposed at a first face 1, a second conductive part exposed at the first face 1, and a third conductive part exposed at a second face 2. A linear part constituting the through-wire 31 extends from the first conductive part in the thick direction of the substrate 11, and reaches a substantially right-angled first bend part. From the substantially right-angled first bend part, the linear part continues extending in parallel with both faces of the substrate 11, and reaches a branched part; it extends farther beyond the branched part and reaches a substantially right-angled second bend part. Also, the linear part constituting the through-wire 31 extends from the second conductive part in the thick direction of the substrate 11, and reaches this substantially right-angled second bend part. Moreover, the linear part also extends from the branched part in the thick direction of the substrate 11, and reaches a third conductive part exposed at the second face 2.
One end of the through-wire 32 is a first conductive part exposed at the first face 1. A linear part constituting the through-wire 32 extends from the one end in the thick direction of the substrate 11, and reaches a substantially right-angled first bend part. From this substantially right-angled first bend part, the linear part continues extending in parallel with both faces of the substrate 11, and reaches a substantially right-angled second bend part; from the substantially right-angled second bend part the linear part continues extending in the thick direction of the substrate 11, and reaches the second conductive part exposed at the second face 2. This second conductive part is another end of the through-wire 32.
The first conductive part and the second conductive part of the through-wire 31 are provided in the first face 1 at positions different from the first conductive part of the through-wire 32. A substantially right-angled first bend part of the through-wire 31 is provided at a position farther from the first face 1 (nearer the rear side) than the substantially right-angled first bend part of the through-wire 32. Moreover, the extension direction of the linear part, which extends from the substantially right-angled first bend part to the substantially right-angled second bend part of the through-wire 32, is 90 degrees different from the extension direction from the substantially right-angled first bend part to the substantially right-angled second bend part of the through-wire 31. Therefore, the through-wire 32 and the through-wire 31 do not interfere with each other by making contact with each other, and, when viewed from the overlap direction of the two faces of the substrate 11, they three-dimensionally intersect and overlap at the overlap section 13.

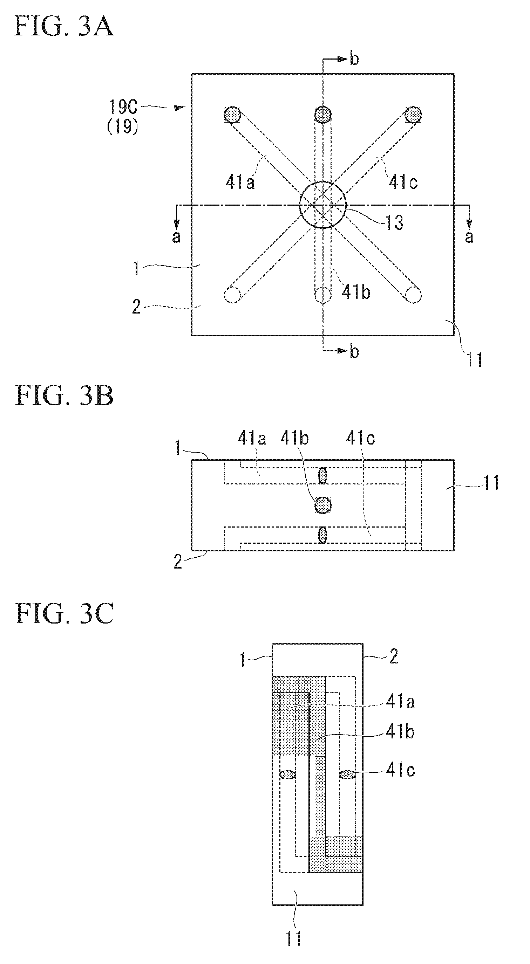

FIGS. 3A to 3C are views of a through wiring substrate 19C (19) according to a third embodiment of the invention. FIG 3A is a plan view of the through wiring substrate 19C. FIG 3B is a cross-sectional view of the through wiring substrate 19C along the line a-a in the plan view of FIG 3A. FIG 3C is a cross-sectional view of the through wiring substrate 19C along the line b-b in the plan view of FIG 3A.
The through wiring substrate 19C includes through-wires 41a, 41b, and 41c disposed in the substrate 11. As shown in FIG 3A, viewed from the overlap direction of a first face and a second face forming the top and bottom of the substrate 11 (the thick direction of the substrate 11), the through-wires 41a, 41b, and 41c include an overlap section 13 where they are separated from each other while overlapping.

As shown in FIGS. 3B and 3C, the through-wires 41a, 41b, and 41c are all crank-shaped.
One end of the through-wire 41a is a first conductive part exposed at the first face 1. A linear part constituting the through-wire 41a extends from the one end (first conductive part) of the through-wire 41a in the thick direction of the substrate 11, and reaches a substantially right-angled first bend part. From the substantially right-angled first bend part, the linear part continues extending parallel with both faces of the substrate 11 and reaches a substantially right-angled second bend part. From the substantially right-angled second bend part, the linear part continues extending in the thick direction of the substrate 11 and reaches a second conductive part exposed at the second face 2. The second conductive part is another end of the through-wire 41a.
The through-wire 41b is crank-shaped similar to the through-wire 41a. A first conductive part of the through-wire 41b is provided on the first face 1 at a position different from the first conductive parts of the through-wires 41a and 41c. A substantially right-angled first bend part of the through-wire 41b is provided at a position farther from the first face 1 (more towards the rear side) than the substantially right-angled first bend part of the through-wire 41a. Moreover, the extension direction of a linear part, which extends from the substantially right-angled first bend part to the substantially right-angled second bend part of the through-wire 41b, is 45 degrees different from the extension direction from the substantially right-angled first bend parts to the substantially right-angled second bend parts of the through-wires 41a and 41c. Therefore, the through-wires 41a and 41c and the through-wire 41b do not interfere with each other by making contact with each other, and, when viewed from the overlap direction of the two faces of the substrate 11, they three-dimensionally intersect and overlap at an overlap section 13.
The through-wire 41c is crank-shaped similar to the through-wires 41a and 41b. A first conductive part of the through-wire 41c is provided on the first face 1 at a position different from the first conductive parts of the through-wires 41a and 41b. A substantially right-angled first bend part of the through-wire 41c is provided at a position farther from the first face 1 (nearer the rear side) than the substantially right-angled first bend part of the through-wire 41b. Moreover, the extension direction of a linear part which extends from the substantially right-angled first bend part to the substantially right-angled second bend part of the through-wire 41c is 90 degrees and 45 degrees different from the extension direction from the substantially right-angled first bend parts to their substantially right-angled second bend parts of the through-wires 41a and 41b respectively. Therefore, the through-wires 41a and 41b and the through-wire 41c do not interfere with each other by making contact with each other, and, when viewed from the overlap direction of the two faces of the substrate 11, they three-dimensionally intersect and overlap at an overlap section 13.

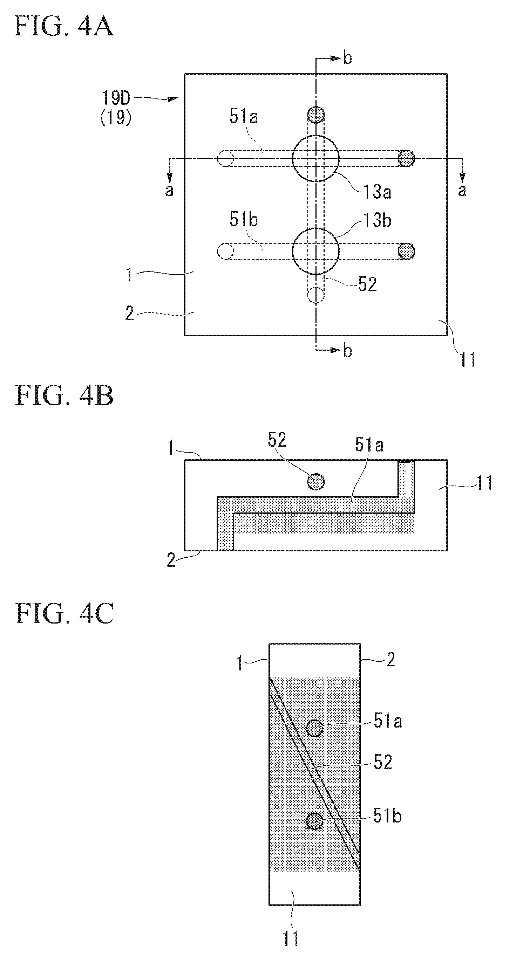

FIGS. 4A to 4C are views of a through wiring substrate 19D (19) according to a fourth embodiment of the invention. FIG 4A is a plan view of the through wiring substrate 19D. FIG 4B is a cross-sectional view of the through wiring substrate 19D along the line a-a in the plan view of FIG 4A. FIG 4C is a cross-sectional view of the through wiring substrate 19D along the line b-b in the plan view of FIG 4A.
The through wiring substrate 19D includes through-wires 51a, 51b, and 52 disposed in the substrate 11. As shown in FIG 4A, viewed from the overlap direction of a first face and a second face forming the top and bottom of the substrate 11 (the thick direction of the substrate 11), the through-wires 51a and 52 are include an overlap section 13a (13) where they are separated from each other while overlapping. Furthermore, as shown in FIG 4A, viewed from the overlap direction of a first face and a second face (the thick direction of the substrate 11), the through-wires 51b and 52 are include an overlap section 13b (13) where they are separated from each other while overlapping.

As shown in FIGS. 4B and 4C, the through-wires 51a and 51b are both crank-shaped, while the through-wire 52 is linear-shaped.
One end of the through-wire 51a is a first conductive part exposed at a first face 1. A linear part constituting the through-wire 51a extends from the one end (first conductive part) of the through-wire 51a in the thick direction of the substrate 11, and reaches a substantially right-angled first bend part. From the substantially right-angled first bend part, the linear part continues extending parallel with both faces of the substrate 11, and reaches a substantially right-angled second bend part. From the substantially right-angled second bend part, the linear part continues extending in the thick direction of the substrate 11, and reaches a second conductive part exposed at a second face 2. The second conductive part is another end of the through-wire 51a.
The through-wire 51b is crank-shaped similar to the through-wire 51a. A first conductive part of the through-wire 51b is provided on the first face 1 at a position different from the first conductive part of the through-wire 51a. A substantially right-angled first bend part of the through-wire 51b and the substantially right-angled first bend part of the through-wire 51a are provided at the same position (distance) from the first face 1. Moreover, the direction and distance of a linear part, which extends from the substantially right-angled first bend part to the substantially right-angled second bend part of the through-wire 51c, are the same as the direction and distance of a linear part, which extends from the substantially right-angled first bend part to the substantially right-angled second bend part of the through-wire 51a. Therefore, the through-wires 51a and 51b do not interfere with each other by making contact with each other.
One end of the through-wire 52 is a first conductive part exposed at a first face 1. A linear part constituting the through-wire 52 extends from the one end (first conductive part) in a direction inclined to the thick direction of the substrate 11, and reaches a second conductive part exposed at a second face 2. This second conductive part is another end of the through-wire 52. The first conductive part and the second conductive part of the through-wire 52 are provided in the first face 1 and the second face 2 at positions different from the first conductive part and the second conductive part of the through-wires 51a and 51b respectively. The overlap section 13a of the through-wire 52 is provided at a shorter distance from the first face 1 than the overlap section 13a of the through-wire 51a (FIG 4C), whereas the overlap section 13b of the through-wire 52 is provided at a greater distance from the first face 1 than the overlap section 13b of the through-wire 51b (FIG 4C). Therefore, the through-wires 51a and 51b and the through-wire 52 do not interfere with each other by making contact with each other, and, when viewed from the overlap direction of the first face 1 and the second face 2 (the thick direction of the substrate 11), they three-dimensionally intersect and overlap at the overlap sections 13a and 13b respectively.

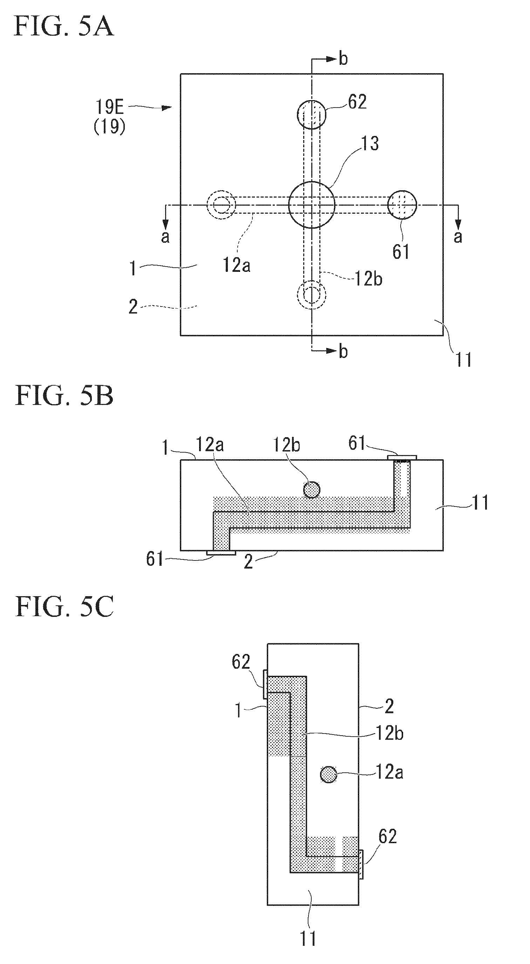

FIGS. 5A to 5C are views of a through wiring substrate 19E (19) according to a fifth embodiment of the invention. FIG 5A is a plan view of the through wiring substrate 19E. FIG 5B is a cross-sectional view of the through wiring substrate 19E along the line a-a in the plan view of FIG 5A. FIG 5C is a cross-sectional view of the through wiring substrate 19E along the line b-b in the plan view of FIG 5A.
The through wiring substrate 19E includes through-wires 12a and 12b, and land parts 61 and 62, disposed in the substrate 11.
As shown in FIG 5A, when viewed from the overlap direction of a first face and a second face forming the top and bottom of the substrate 11 (the thick direction of the substrate 11), the through-wires 12a and 12b include an overlap section 13 where they are separated from each other while overlapping.

As shown in FIGS. 5B and 5C, the through-wires 12a and 12b are both crank-shaped, the explanation of their shape being the same as that of the through-wires 12a and 12b in the through wiring substrate 19A shown in FIGS. 1A to 1C.
A circular land part 61 is provided on a first conductive part and a second conductive part of the through-wire 12a. A circular land part 62 is provided on a first conductive part and a second conductive part of the through-wire 12b.
By providing the land parts 61 and 62, it becomes possible to mount devices and the like on both faces of the substrate 11 using solder bumps and the like.

The land parts 61 and 62 include one or more layers of conductive thin-film. There are no particular restrictions on the material used for these land parts, it being possible to use, for example, gold (Au), nickel (Ni), titanium (Ti), etc. These materials enable land parts having the desired shapes to be formed using a publicly known method.

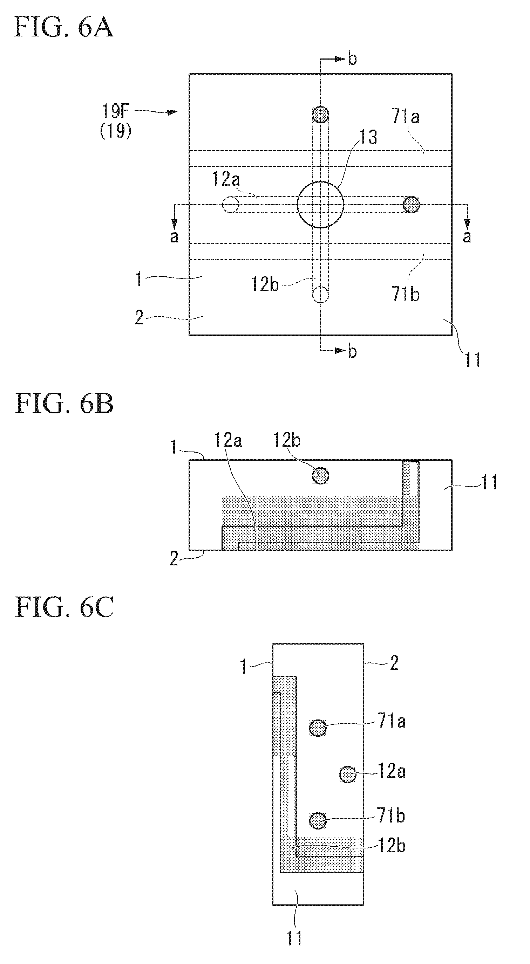

FIGS. 6A to 6C are views of a through wiring substrate 19F (19) according to a sixth embodiment of the invention. FIG 6A is a plan view of the through wiring substrate 19F. FIG 6B is a cross-sectional view of the through wiring substrate 19F along the line a-a in the plan view of FIG 6A. FIG 6C is a cross-sectional view of the through wiring substrate 19F along the line b-b in the plan view of FIG 6A.
The through wiring substrate 19F includes through-wires 12a and 12b, and flow paths 71a and 71b, disposed in the substrate 11.
As shown in FIG 6A, when viewed from the overlap direction of a first face and a second face forming the top and bottom of the substrate 11 (the thick direction of the substrate 11), the through-wires 12a and 12b include an overlap section 13 where they are separated from each other while overlapping.

As shown in FIGS. 6A to 6C, the through-wires 12a and 12b are both crank-shaped, and the explanation of their shape is the same as that of the through-wires 12a and 12b in the through wiring substrate 19A shown in FIGS. 1A to 1C.
The flow paths 71a and 71b are both linear-shaped; they are disposed along the through-wire 12a in parallel with both faces (a first face and a second face) of the substrate 11, and penetrate the side face of the substrate 11 (the cross-sectional face in the thick direction of the substrate 11).
The flow paths 71a and 71b can be used for flowing, for example, a cooling fluid. Alternatively, flow paths for flowing living solutions such as DNA (nucleic acid), protein, and fat, can also be used as the flow paths 71a and 71b. For example, when the flow paths 71a and 71b are used for flowing a cooling fluid, it becomes possible to cool the through wiring substrate 19F, so that even if a device that generates considerable heat is mounted on the substrate, the device can be cooled effectively. For example, water (H₂O), air, or the like, can be used as a cooling medium.
By using the through wiring substrate according to this embodiment, even if the mounted devices are miniature ones with electrodes disposed at high density, when the substrate interior includes, for example, flow paths for cooling fluid, the rise in temperature of the devices can be effectively reduced.
As described below, the flow paths 71a and 71b can be formed in the substrate 11 using a method similar to that for forming the through-holes that become the through-wire 12a and 12b.
While in FIG 6C, the flow paths 71a and 71b are provided nearer to the first face 1 of the substrate 11 than the through-wire 12a, the configuration is not restricted to this. The flow paths 71a and 71b can also be provided at the same position as the through-wire 12a, i.e. at the same position from the first face 1 of the substrate 11. In this embodiment, the flow paths 71a and 71b are provided along the through-wire 12a in parallel with both faces of the substrate 11. However, the flow paths 71a and 71b can also be provided along the through-wire 12b and in parallel with both face of the substrate 11.

As the material for the substrate 11 in the through wiring substrate 19 of the invention described above, for example, an insulating body such as glass, sapphire, plastic, and ceramic, or a semiconductor such as silicon (Si), is used. Of these materials, insulating silica glass is preferable. When the substrate material is silica glass, this obtains advantages that there is no need to form an insulating layer on the inner wall of the through-hole as described below, there is no obstruction of high-speed transmission due to the existence of floating capacitance and the like, and the flow paths for the cooling fluid have good stability, etc.
One device conceivably mounted on both faces of the substrate is an electronic device including elements formed on a silicon substrate. When there is a large difference in the linear thermal expansion coefficients of the electronic device and the substrate, there are cases where their amounts of growth due to the temperature when mounted differ greatly. As a result, there will be deviation in the positions of the terminals of the device and the pads of the substrate, making it difficult to connect them precisely, or, depending on the case, making connection itself difficult. Since the substrate according to this embodiment can be made from silicon or glass, it can reduce difference in the linear thermal expansion coefficients of the electronic device and the substrate. Therefore, deviation in the positions of the device terminals and the pads of the substrate can be suppressed, and they can be connected precisely.
The thickness of the substrate 2 (the distance from the first face 1 to the second face 2) can be set as appropriate within a range of approximately 150 µm to 1 mm.

The patterns and cross-sectional shapes of the through-wires provided in the through wiring substrate of the invention are not limited to those illustrated above, and can be designed as appropriate. Similarly, the patterns (routes) and cross-sectional shapes of the flow paths provided in the through wiring substrate of the invention are not limited to those illustrated above, and can be designed as appropriate.

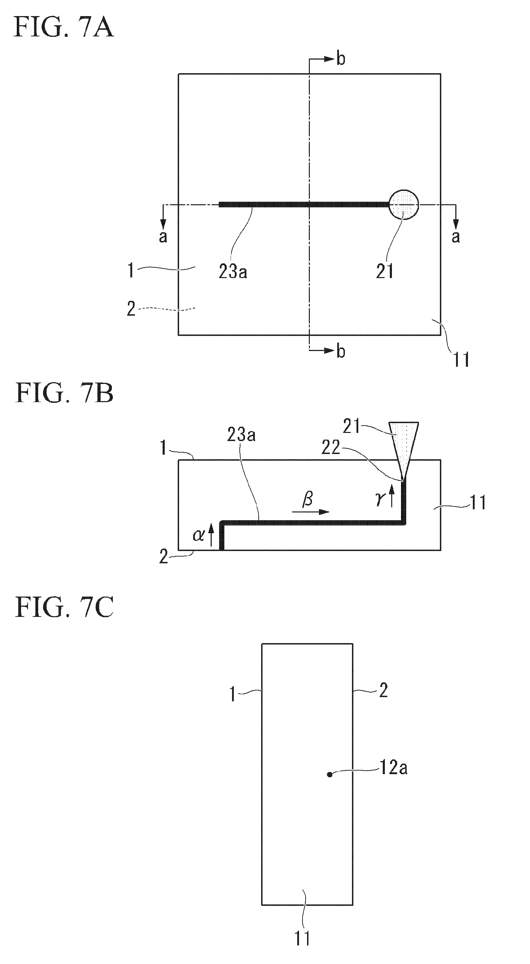

Subsequently, as an example of a method of manufacturing the through wiring substrate 19, FIGS. 7A to 10C, and FIGS. 11A to 13C illustrate a method of manufacturing the through wiring substrate 19A.
FIGS. 7A to 10C, and FIGS. 11A to 13C, are plan views and cross-sectional views of a substrate 11 for manufacturing the through wiring substrate 19A. Of these, FIGS. 7A, 8A, 9A, 10A, 11A, 12A, and 13A are plan views of the substrate 11, FIGS. 7B, 8B, 9B, 10B, 11B, 12B, and 13B are cross-sectional views of the through wiring substrate 11 along the line a-a of those respective plan views, and FIGS. 7C, 8C, 9C, 10C, 11C, 12C, and 13C are cross-sectional views of the through wiring substrate 11 along the line b-b of those respective plan views.

### <Process A>

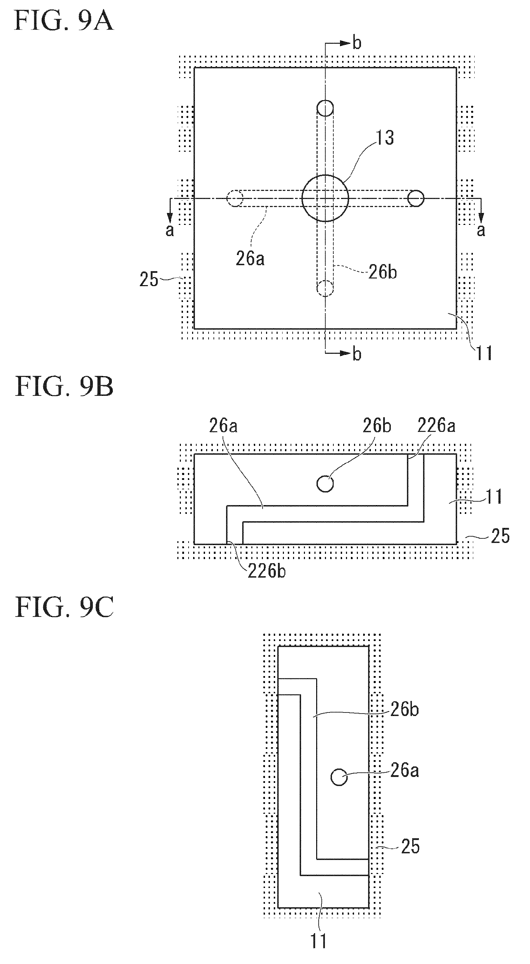

Firstly, as shown in FIGS. 7A to 7C, a modified part 23a is formed in the substrate 11 by irradiating the substrate 11 with laser light 21 to modify the material of the substrate 11. The modified part 23a is provided in a region (through-hole formation region) that will become a through-hole 26a (FIG 9A) for forming the through-wire 12a.

As the material for the substrate 11, for example, an insulating body such as glass, sapphire, plastic, and ceramic, or a semiconductor such as silicon (Si), is used. Of these materials, insulating silica glass is preferable. When the substrate material is silica glass, this obtains advantages that there is no need to form an insulating layer on the inner wall of the through-hole as described below, there is no obstruction of high-speed transmission due to the existence of floating capacitance and the like, and the flow paths for the cooling liquid have good stability, etc.
The thickness of the substrate 11 (the distance from the first face 1 to the second face 2) can be set as appropriate within a range of approximately 150 µm to 1 mm.

The laser light 21 is, for example, irradiated from the first face 1 side of the substrate 11 and forms a focal point 22 at a desired position in the substrate 11. The material of the substrate 11 is modified at the position of focal point 22. Therefore, when the position of the focal point 22 is moved (scanned) sequentially while irradiating the laser light 21, the modified part 23a can be formed by forming the focal point 22 in the entirety of the region that will become the through-hole 26a.

A femtosecond laser is one example of a light source that can be used as the laser light 21. Irradiation of the laser light 21 can obtain the modified part 23a (23b) with a diameter of, for example, several µm to several tens of µm. Also, by controlling the position of the focal point 22 of the laser light 21 in the substrate 11, it is possible to form the modified part 23a (23b) having the desired shape. In general, unlike laser transmittance in an unmodified section, in the case of laser transmittance in a modified section, it is usually difficult to control the focal point position of laser light that has been transmitted through the modified section.

The arrows in the cross-sectional view of FIG 7B indicate the scanning direction of the focal point 22 of the laser light 21. Arrow α indicates that the focal point 22 is scanned from the second face 2 (opening in the second face) to a substantially right-angled second bend part (second substantially right-angled part). Arrow β indicates that the focal point 22 is scanned from the substantially right-angled second bend part to a substantially right-angled first bend part. Arrow γ indicates that the focal point 22 is scanned from the substantially right-angled first bend part to the first face 1 (opening in the first face). At this time, with regard to the manufacturing efficiency, scanning is preferably performed in a single line in the directions of the arrows α, β, and γ in that order.

When scanning is not performed in a single line, the scanning direction indicated by the arrow β can be reversed. The scanning directions indicated by the arrows α and γ, on the other hand, are preferably not reversed. If they are reversed, viewed in the thick direction of the substrate 11, scanning is performed from the first face 1 side (the front) to the second face 2 side (the rear), and it becomes difficult to transmit the laser light 21 through the modified part at the front so as to form the focal point 22 at the rear side. This is due to scattering of the laser light 21 resulting from the changed laser transmittance of the modified part. Therefore, when the laser light 21 is incident from the first face 1 side of the substrate 11, scanning can be performed while forming the focal point 22 sequentially from the second face 2 side of the rear side to the first face 1 side of the front side. When the laser light 21 is incident from the second face 2 side of the substrate 11, the first face 1 side becomes the rear side, and thus scanning can be performed while forming the focal point 22 sequentially from the first face 1 side to the second face 2 side.

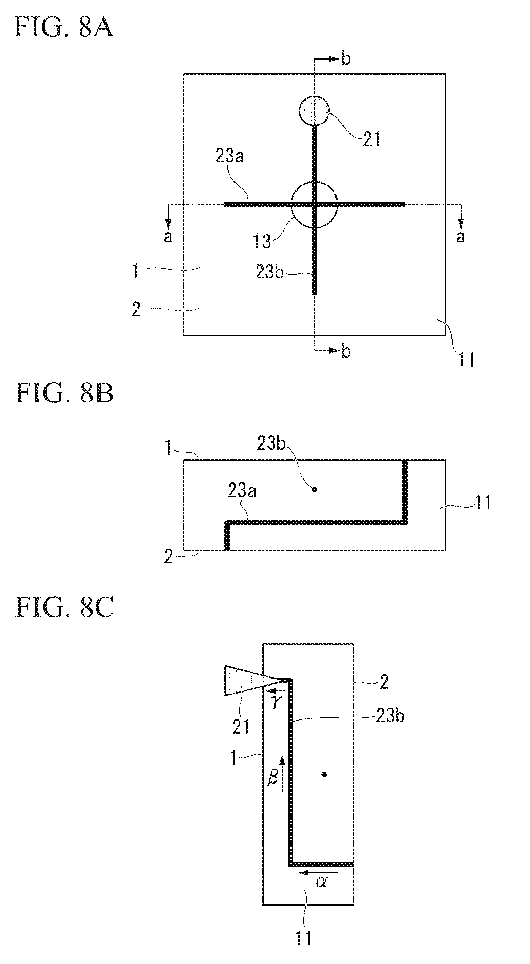

As shown in FIGS. 8A to 8C, the substrate 11 then is irradiated with the laser light 21 to modify the material of the substrate 11 and thus form the modified part 23b in the substrate 11. The modified part 23b is provided in a region that will become a through-hole 26b.
The modified part 23b can be formed by sequentially moving (scanning) the position of the focal point 22 while irradiating the laser light 21, forming the focal point 22 across the entire region that will become the through-hole 26b.

The arrows in the cross-sectional view of FIG 8C indicate scanning directions of the focal point 22 of the laser light 21. Arrow α indicates that the focal point 22 is scanned from the second face 2 (opening in the second face) to the substantially right-angled second bend part (second substantially right-angled part). Arrow β indicates that the focal point 22 is scanned from the substantially right-angled second bend part to the substantially right-angled first bend part (first substantially right-angled part). Arrow γ indicates that the focal point 22 is scanned from the substantially right-angled first bend part to the first face 1 (opening in the first face). At this time, with regard to the manufacturing efficiency, scanning is preferably performed in a single line in the directions of the arrows α, β, and γ in that order. When scanning is not performed in a single line, the scanning direction indicated by the arrow β can be reversed. The scanning directions indicated by the arrows α and γ, on the other hand, are preferably not reversed. When the laser light 21 is incident from the second face 2 side of the substrate 11, scanning can be performed while forming the focal point 22 sequentially from the first face 1 side to the second face 2 side.

When the substrate 11 with the modified parts 23 a and 23b formed therein is viewed in its thick direction, at an overlap section 13 where the modified part 23 a and the modified part 23b are separated from each other while overlapping, the modified part 23a includes an overlap section that is far from the first face 1, and the modified part 23b includes an overlap section that is near to the first face 1.

The method of forming the modified parts 23a and 23b need only be one where the overlap section 13 of the modified part 23 a is formed first, and the overlap section 13 of the modified part 23b is formed thereafter, there being no particular restrictions. In other words, the method need only be one where, when the laser light 21 is incident from the first face 1 side of the substrate 11, a modified part having an overlap section that is far from the first face 1 (incident side of laser light 21) is formed first, and a modified part having an overlap section that is near to the first face 1 (incident side of laser light 21) is formed thereafter.
For example, as shown in FIGS. 7A to 8C, a method can be employed, namely of the regions that will become the through-hole 26a and the through-hole 26b including the overlap section 13 where they are separated from each other while overlapping when viewed from the thickness direction of the substrate 11, the modified part 23a corresponding to the region (through-wire formation region) that will become the through-hole 26a including the overlap section that is far from the first face 1 which the laser is incident to is first entirely modified by laser-irradiation. Thereafter, the modified part 23b corresponding to the region (through-wire formation region) that will become the through-hole 26b including the overlap section that is near to the first face 1 is then entirely modified by laser irradiation.

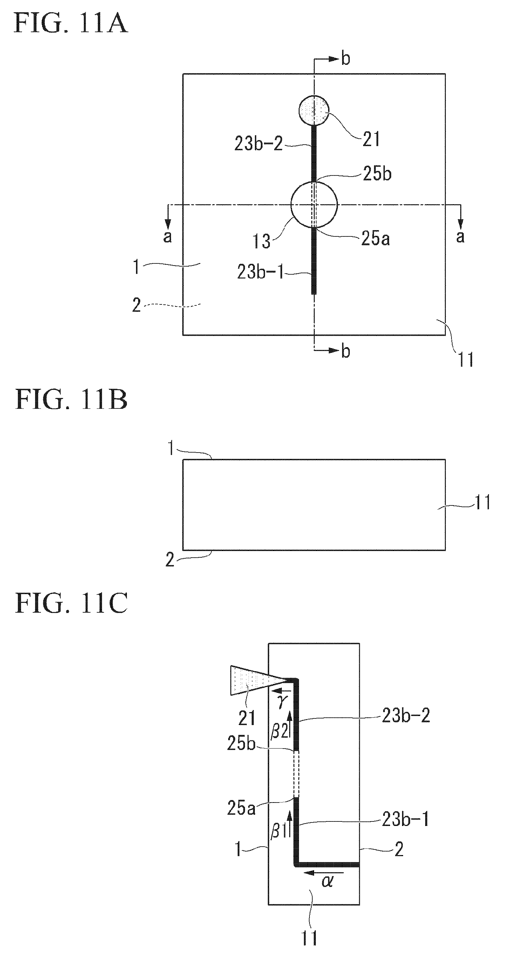

As described later in FIGS. 11A to 13C, there is a method of forming the modified parts 23a and 23b by first forming the section of the modified part 23b excepting the overlap section 13 (modified parts 23b-1 and 23b-2), then forming the entire modified part 23a, and lastly forming the overlap section 13 of the modified part 23b. This method is an example of a method wherein, of the regions that will become the through-hole 26a and the through-hole 26b including the overlap section 13 where they are separated from each other while overlapping when viewed fro the thickness direction of the substrate 11, the overlap section that is far from the first face 1 which the laser is incident to (overlap section 13 of the through-hole 26a) is first modified by laser irradiation, the overlap section that is near to the first face 1 (overlap section 13 of the through-hole 26b) is then modified by laser irradiation.
As another example, there is a method of first forming the overlap section 13 of the modified part 23a, then forming the overlap section 13 of the modified part 23b, and thereafter forming the section of the modified part 23a excepting the overlap section and the section of the modified part 23b excepting the overlap section. That is, as long as the incident laser light is not transmitted through the modified section, the sequence of forming the modified parts 23a and 23b can be adjusted as appropriate. In other words, as long as the overlap section far from the face which the laser light is incident to is formed first, there are no particular restrictions on the sequence of forming the other sections.

The method shown in FIGS. 11A to 13C will be explained. Firstly, in FIGS. 11A to 11C, the substrate 11 is irradiated with the laser light 21 to modify the material of the substrate 11 and thus form the modified parts 23b-1 and 23b-2 in the substrate 11. The modified parts 23b-1 and 23b-2 are formed at the following respective positions in the region that will become the through-hole 26b.
The modified part 23b-1 is formed in a section including the section from the second face 2 (opening in the second face) to the substantially right-angled second bend part, and the section from the substantially right-angled second bend part to a position 25a, of the region that will become the through-hole 26b. The modified part 23b-2 is formed in a section including the section from the position 25a to the substantially right-angled first bend part, and the section from the substantially right-angled first bend part to the first face 1 (opening in the first face), of the region that will become the through-hole 26b. The section from the position 25a to a position 25b corresponds to the overlap section 13 of the through-hole 26b.

The arrows in the cross-sectional view of FIG 11C indicate the scanning direction of the focal point 22 of the laser light 21. Arrow α indicates that the focal point 22 is scanned from the second face 2 (opening in the second face) to the substantially right-angled second bend part. Arrow β1 indicates that the focal point 22 is scanned from the substantially right-angled second bend part to the position 25a. Arrow β2 indicates that the focal point 22 is scanned from the position 25b to the substantially right-angled first bend part. Arrow γ indicates that the focal point 22 is scanned from the substantially right-angled first bend part to the first face 1 (opening in the first face). At this time, with regard to the manufacturing efficiency, scanning is preferably performed in the directions of the arrows α, β1, β2, and γ in that order. The scanning directions of the arrows β1 and β2 can be reversed. The scanning directions indicated by the arrows α and γ, on the other hand, are preferably not reversed.

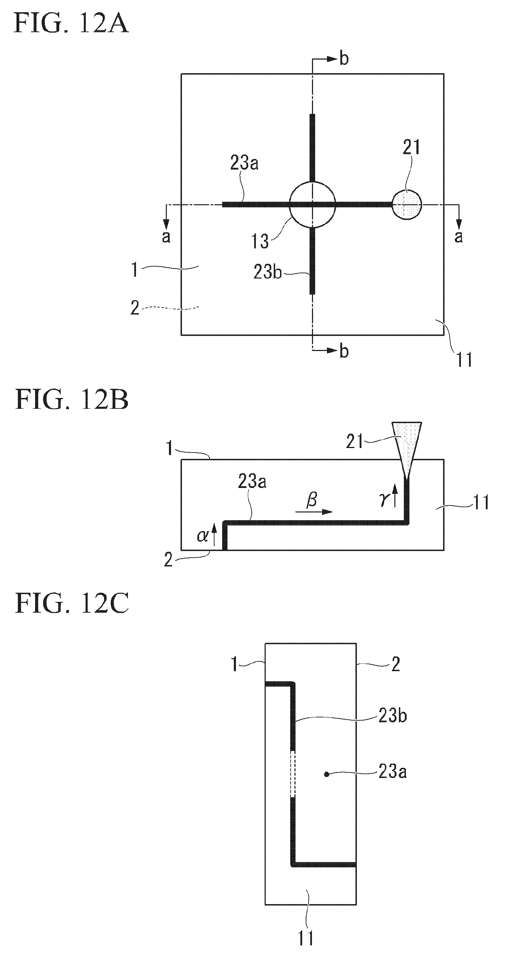

As shown in FIGS. 12A to 12C, the substrate 11 is then irradiated with the laser light 21 to modify the material of the substrate 11 and thus form the modified part 23a in the substrate 11. The modified part 23a is provided in a region that will become a through-hole 26a. The modified part 23a can be formed by sequentially moving (scanning) the position of the focal point 22 while irradiating the laser light 21, forming the focal point 22 across the entire region that will become the through-hole 26a. The overlap section 13 of the modified part 23b corresponding to the section that will become the overlap section 13 of the through-hole 26b is not formed at this time. Therefore, the laser light 21 can be transmitted through the overlap section 13 of the modified part 23b prior to modification, and the focal point 22 can be formed in the overlap section 13 of the modified part 23a corresponding to the section that will become the through-hole 26a.

The arrows in the cross-sectional view of FIG 12B indicate scanning directions of the focal point 22 of the laser light 21. Arrow α indicates that the focal point 22 is scanned from the second face 2 (opening in the second face) to the substantially right-angled second bend part. Arrow β indicates that the focal point 22 is scanned from the substantially right-angled second bend part to the substantially right-angled first bend part. Arrow γ indicates that the focal point 22 is scanned from the substantially right-angled first bend part to the first face 1 (opening in the first face). At this time, with regard to the manufacturing efficiency, scanning is preferably performed in a single line in the directions of the arrows α, β, and γ in that order. When scanning is not performed in a single line, the scanning direction indicated by the arrow β can be reversed. The scanning directions indicated by the arrows α and γ, on the other hand, are preferably not reversed.

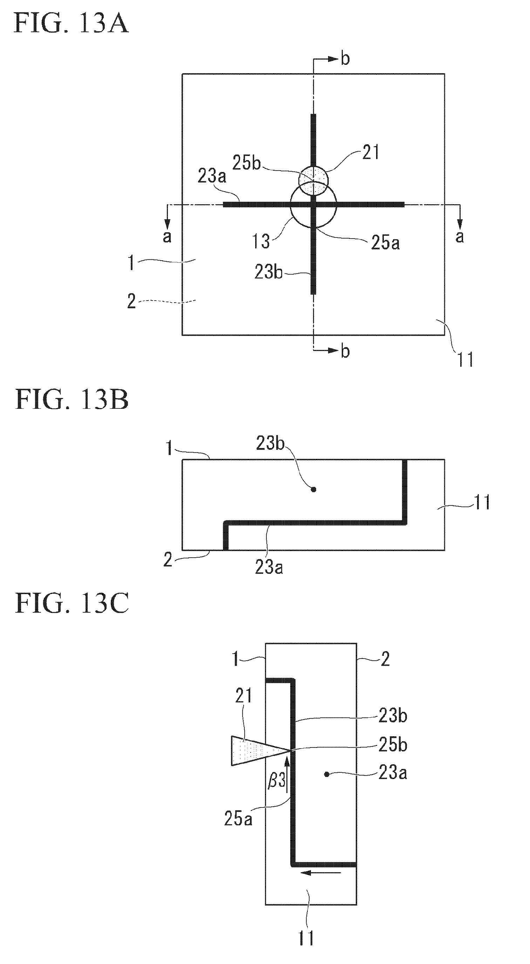

As shown in FIGS. 13A to 13C, the substrate 11 is then irradiated with the laser light 21 to modify the material of the substrate 11 and thus form the overlap section 13 of the modified part 23b in the substrate 11. The overlap section 13 of the modified part 23b is provided in the section from the position 25a to the position 25b of the region that will become the through-hole 26b.
The overlap section 13 of the modified part 23b can be formed by sequentially moving (scanning) the position of the focal point 22 while irradiating the laser light 21, forming the focal point 22 across the section from the position 25a to the position 25b of the region that will become the through-hole 26b. At this time, the modified part 23b corresponding to the entire region that will become the through-hole 26b can be formed by irradiating the laser light 21 such as to smoothly connect the modified parts 23b-1 and 23b-2, which have already been formed, to the overlap section 13 of the modified part 23b.

The arrows in the cross-sectional view of FIG 13C indicate scanning directions of the focal point 22 of the laser light 21. Arrow β3 indicates that the focal point 22 is scanned from the position 25a to the position 25b. The scanning direction indicated by the arrow β3 can be reversed.

As described above, the method shown in FIGS. 7A to 8C, and the method shown in FIGS. 11A to 13C can obtain the substrate 11 with the modified parts 23 a and 23b formed therein.

In process (A) of the method of manufacturing the through wiring substrate 19 according to the invention described above, the modified parts 23a and 23b were formed by laser irradiation from the first face 1 side of the substrate 11 across the entirety of the region that will become the through-hole 26a and the through-hole 26b including the overlap section 13 viewed in the thick direction of the substrate 11. However, if desired, the modified parts 23 a and 23b can be formed by laser irradiation from the second face 2 side of the substrate 11. In this case, the overlap section 13 of the modified part 23b need only be irradiated with the laser from the first face 1 side, and the overlap section 13 of the modified part 23a need only be irradiated with the laser from the second face 2. That is, in a given section of the region that will become a plurality of through-holes 26a and through-holes 26b that include overlap sections 13 where they are separated from each other while overlapping viewed in the thick direction of the substrate 11, the section near the first face 1 is irradiated with the laser from the first face 1 side, and the section near the second face 2 side is irradiated with the laser from the second face 2 side, whereby the modified parts 23a and 23b can be formed. In this case, one laser device can be provided at each of the two face sides of the substrate 11. Alternatively, irradiation can be carried out by making one laser device go back and forth between the first face 1 side and the second face 2 side of the substrate 11.
Alternatively, irradiation can be carried out by fixing one laser device in place, and overturning the substrate 11 so as to switch the positional relationship between the first face 1 and the second face 2.

### <Process B>

As shown in FIGS. 9A to 9C, the substrate 11 with the modified parts 23 a and 23b formed therein is immersed in an etching solution (chemical solution) 25 and the modified parts 23a and 23b are thus removed from the substrate 11 by etching (wet etching). As a result, the through-holes 26a and 26b are formed in the section where the modified parts 23a and 23b are present. In this embodiment, silica glass is used as the material for the substrate 11, and a solution with a main element of hydrofluoric acid (HF) is used as the etching solution 25. This etching procedure utilizes the phenomenon whereby the modified parts 23a and 23b are etched much faster than the unmodified sections of the substrate 11, and enables the through-holes 26a and 26b to be formed in correspondence with the shapes of the modified parts 23a and 23b. At this stage, one end of the through-hole 26a is a first opening 226a exposed at one face of the substrate 11. Another end of the through-hole 26a is a second opening 226b exposed at another face of the substrate 11. A first conductive part 112a is formed in the first opening 226a, and a second conductive part 112b is formed in the second opening 226b, by filling, or forming a film of, an electrically-conductive substance in the through-hole 26a.

There are no particular restrictions on the etching solution 25, it being possible to use, for example, a solution with hydrofluoric acid (HF) as its main element, or a fluoro-nitric mixed acid obtained by doping hydrofluoric acid with an appropriate amount of nitric acid, or such like. It is also possible to use another chemical solution, according to the material of the substrate 11.

After the through-holes have been formed in the substrate 11, in process (C) explained below, through-wires can be formed by filling, or forming a film of, an electrically-conductive substance in the through-holes. By flowing a cooling medium into the through-holes formed in the substrate 11, the through-holes can be used as flow paths for cooling.

### <Process C>

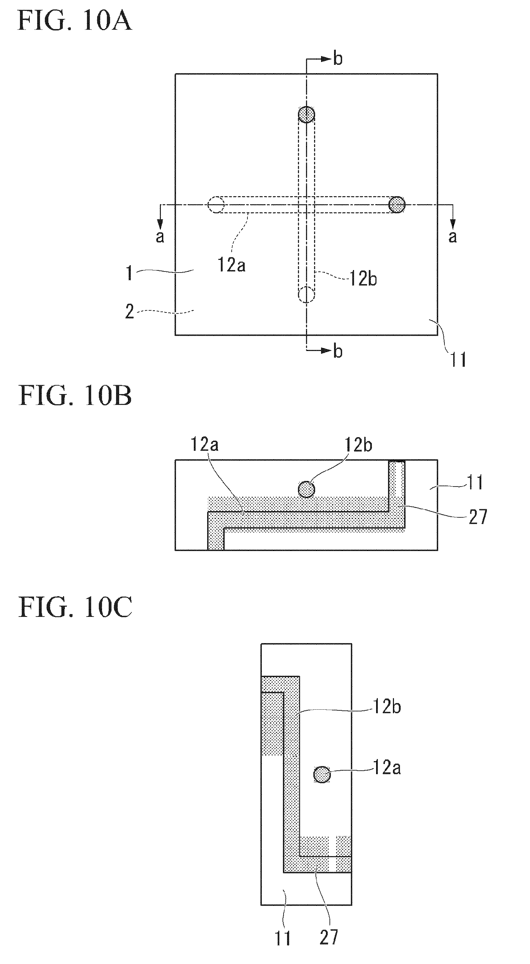

When the through-holes 26a and 26b have been formed in the substrate 11 as shown in FIGS. 10A to 10C, the through-wires 12a and 12b are formed by filling, or forming a film of, an electrically-conductive substance 27 in the through-holes 26a and 26b. For example, gold-tin (Au-Sn), copper (Cu), or such like can be used as the electrically-conductive substance 27. To make the electrically-conductive substance 27, a method such as molten metal suction method or supercritical fluid deposition can be used.
Preferably, when the flow paths are formed in the substrate 11, the openings of the flow paths are temporarily closed by providing a protective layer such as a resist over them, to ensure that the electrically-conductive substance does not infiltrate the flow paths. For example, a resin resist, a thin film of inorganic material, or such like, can be used as this resist. By providing the protective layer, it is possible to prevent the electrically-conductive substance from being infiltrated to the flow paths. The protective layer is removed after the electrically-conductive substance has been filled, or formed as a film, in the through-hole.

If necessary, as shown in FIGS. 5A to 5C, the land parts 61 and 62 can be formed over the openings in the through-wires 12a and 12b. The land parts 61 and 62 can be formed by a method such as plating or sputtering, as appropriate.

Water, air, or the like, can be used as the cooling medium flowed into the through-holes formed in process (B). When air is used as the cooling medium, the substrate 11 can be air-cooled. When the water is used as the cooling medium, the substrate 11 can be liquid-cooled.
To flow air as a cooling medium into the through-holes, a pump or the like can be externally connected as appropriate, and water or the like can be flowed through it.

The method of manufacturing the through wiring substrate 19F including the flow paths 71a and 71b shown in FIGS. 6A to 6C is one example of a method of manufacturing a through wiring substrate including flow paths in the substrate.
Firstly, the substrate 11 is irradiated with the laser light 21 to modify the material of the substrate 11, thus forming modified parts in the substrate 11. These modified parts are formed in regions that will become the through-wires 12a and 12b, and the flow paths 71a and 71b, respectively.
The modified parts can be formed by sequentially moving (scanning) the position of the focal point 22 while irradiating the laser light 21, forming the focal point 22 across the entire regions that will become the through-wires 12a and 12b, and the flow paths 71a and 71b. At this time, laser irradiation is performed from the first face 1 side of the substrate 11. As described above, where necessary, laser irradiation can be performed from the second face 2 side, or from both the first face 1 and the second face 2 sides.

A method of irradiating the laser only from the first face 1 side will be explained, taking as an example of the through wiring substrate 19F shown in FIGS. 6A to 6C.
Firstly, when viewed in the thick direction of the substrate 11, the flow paths 71a and 71b and the through-wire 12a do not include overlap sections where they are separated from each other while overlapping. Therefore, there are no particular restrictions on the order of forming the modified part that will become the through-wire 12a and the modified parts that will become the flow paths 71a and 71b, and it does not matter which is formed first.
With attention to the positional relationship between the overlap parts of the modified part that will become the through-wire 12b, and the modified parts that will become the through-wire 12a, the flow path 71a, and the flow path 71b when viewed in the thick direction of the substrate 11, the modified part that will become the through-wire 12a having an overlap part at a position far from the first face 1, and the modified parts that will become the flow path 71a and the flow path 71b are formed first, and the modified part that will become the through-wire 12b having the overlap part at a position near to the first face 1 is formed thereafter. By irradiating the laser from the first face 1 side in this order, each of the modified parts can be formed.

The substrate 11 with the modified parts formed therein is then immersed in the etching solution (chemical solution), and the modified parts are thus removed from the substrate 11 by etching (wet etching). As a result, the through-holes that become the through-wires 12a and 12b are formed in the sections where the respective modified parts are present, and the through-holes that become the flow paths 71a and 71b are simultaneously formed.
If the through-holes that will become the through-wires and the through-holes that will become the flow paths are formed simultaneously in this way, the manufacturing process can be simplified and the cost can be reduced.
In process (C), the through-wires 12a and 12b can be formed by filling, or forming a film of, an electrically-conductive substance in the through-holes that will become the through-wires.
The method described above can manufacture a through wiring substrate including the intended flow paths.

In the method of manufacturing the through wiring substrate of the invention, in process (A), in determining whether an overlap section is near to or far from the first face 1, it is determined only whether sections which are separated from each other while overlapping are relatively near to or far from the first face 1.
In the explanation of the invention, 'viewed in the overlap direction of two faces of the substrate, of the overlap section where through-wires are separated from each other while overlapping, the overlap section of one of the through-wires' is sometimes shortened to 'overlap section'.

### INDUSTRIAL APPLICABILITY

The through wiring substrate of the invention can be used in high-density mounting of various devices, such as a three-dimensional mount wherein devices aer mounted on two electrically-connected faces, a system-in-package (SiP) wherein a plurality of devices are systemized in a single package, etc.

### REFERENCE NUMERALS

- 1: FIRST FACE
- 2: SECOND FACE
- 11: SUBSTRATE
- 12: THROUGH-WIRE
- 13: OVERLAP SECTION
- 16: THROUGH-WIRE
- 21: LASER LIGHT
- 23: MODIFIED REGION (MODIFIED PART)
- 25: ETCHING SOLUTION
- 27: ELECTRICALLY-CONDUCTIVE SUBSTANCE
- 31: THROUGH-WIRE
- 32: THROUGH-WIRE
- 41: THROUGH-WIRE
- 51: THROUGH-WIRE
- 52: THROUGH-WIRE
- 61: LAND PART
- 62: LAND PART
- 71: FLOW PATH
- 19F: THROUGH WIRING SUBSTRATE WITH FLOW PATH
- 19, 19A, 19B, 19C, 19D, 19E: THROUGH WIRING SUBSTRATE

## Claims

1. A through wiring substrate comprising:
a substrate including a first face and a second face; and
a plurality of through-wires formed by filling, or forming a film of, an electrically-conductive substance in through-holes that penetrate between the first face and the second face,
wherein the through-wires are separated from each other, and include at least one overlap section in a plan view of the substrate.

2. The through wiring substrate according to claim 1, wherein
a flow path is formed in an interior of the substrate.

3. The through wiring substrate according to claim 1 or 2, wherein
the plurality of through-wires includes a plurality of first through-wires, formed along a first direction parallel with the first face of the substrate, and a plurality of second through-wires, formed along a second direction that intersects the first direction.

4. The through wiring substrate according to one of claims 1 to 3, wherein
the plurality of through-wires include a first conductive part formed on the first face of the substrate, and a second conductive part formed on the second face of the substrate; and
the first conductive part and the second conductive part are formed at mutually different positions when viewed from a thick direction of the substrate.

5. A method of manufacturing a through wiring substrate which comprises a substrate including a first face and a second face, and a plurality of through-wires formed by filling, or forming a film of, an electrically-conductive substance in through-holes that penetrate between the first face and the second face, in which the through-wires are separated from each other, and include at least one overlap section in a plan view of the substrate, the method comprising:
a process (A) of laser-irradiating a plurality of through-hole formation regions which are separated from each other and include an overlap section in a plan view of the substrate, from the first face or the second face of the substrate, and thereby modifying the through-hole formation regions; and
a process (B) of removing the modified through-hole formation regions to form through-holes,
wherein in the process (A), of the plurality of through-hole formation regions, after laser-irradiating the overlap section which is far from the laser incident face, the overlap section which is near to the laser incident face is laser-irradiated.

6. The method of manufacturing a through wiring substrate according to claim 5, wherein
in the process (A), after laser-irradiating the entirety of the through-hole formation region having the overlap section far from the laser incident face, the entirety of the through-hole formation region having the overlap section near to the laser incident face is laser-irradiated.

7. A method of manufacturing a through wiring substrate which comprises a substrate including a first face and a second face, and a plurality of through-wires formed by filling, or forming a film of, an electrically-conductive substance in through-holes that penetrate between the first face and the second face, in which the through-wires are separated from each other, and include at least one overlap section in a plan view of the substrate, the method comprising:
a process (A) of laser-irradiating a plurality of through-hole formation regions which are separated from each other and include an overlap section in a plan view of the substrate, from the first face and the second face of the substrate, and thereby modifying the through-hole formation regions; and
a process (B) of removing the modified through-hole formation regions to form through-holes,
wherein in the process (A), the through-hole formation regions including the overlap section near to the first face are laser-irradiated from the first face side of the substrate, and the through-hole formation regions including the overlap section which is near to the second face are laser-irradiated from the second face side of the substrate.

8. The method of manufacturing the through wiring substrate according to one of claims 5 to 7, the method comprises a process (C) of filling, or forming a film of, the electrically-conductive substance in the through-holes.
